# EUROPEAN PATENT SPECIFICATION

(11) **EP 0 732 040 B1**
(45) Date of publication and mention of the grant of the patent: **11.02.1998**
(21) Application number: 95904600.4
(22) Date of filing: 02.12.1994
(51) Int. Cl.: H05K 3/42

(54) **METHOD OF MAKING A PRINTED CIRCUIT BOARD**
VERFAHREN ZUR HERSTELLUNG EINER LEITERPLATTE
PROCEDE DE FABRICATION D'UNE CARTE DE CIRCUITS IMPRIMES

(30) Priority: 03.12.1993 GB 9324848
(43) Date of publication of application: 18.09.1996
(73) Proprietor: MACDERMID INCORPORATED, Waterbury, Connecticut 06702 (US)
(72) Inventor: Knopp, John Frederick David, Braintree, Essex CM7 5NR (GB)
(74) Representative: Loven, Keith James
(86) International application number: GB9402651
(87) International publication number: WO9515674

(56) References cited:
- FR-A- 1 431 918
- GB-A- 1 056 814
- GB-A- 2 051 489
- GB-A- 2 227 124
- US-A- 4 512 829
- PATENT ABSTRACTS OF JAPAN vol. 14, no. 441 (E-0981) 20 September 1990 & JP,A,02 174 193 (NIPPON MINING CO) 5 July 1990

## Description

### Field of the Invention

This invention relates to a method of making a printed circuit board of the plate through hole type, and in particular to a method using board of the paper phenolic material type.

Plate through hole (PTH) boards have conductive circuit elements formed on both sides and interconnected by holes drilled through the board from a conductive element on one side to an opposed element on the other side, the holes having conductive metal plated therethrough.

### Background to the Invention

In my earlier published application WO93/26145 forming state of the art according to Articles 54(3) and 158(3) EPC, I disclosed and claimed a method of making PTH boards using electroless plating. While the general method is suitable for use on a wide range of substrates, it has not been possible to use the most widely-used substrate, laminated paper bonded with phenolic resins, referred to as "paper phenolic materials", because prolonged exposure to the hot alkaline copper plating solutions required causes breakdown of the substrate, and because such materials contain traces of antimony, which can poison a copper-plating bath and render it ineffective.

GB A 2227124 discloses a method of plating through holes in paper phenolic materials, by coating the conductive cicuit with a protective film, which is chemically or mechanically removed in areas around the holes before plating. The protective film is only removed in areas from 0.01-0.5 mm around the holes.

### Summary of the Invention

The present invention provides a method of making a plate through hole printed circuit board, comprising the steps of:
a) forming conductive circuit elements on two opposed faces of a paper phenolic containing substrate;
b) coating the substrate and circuit elements with a de-sensitising material;
c) forming holes through the substrate, each hole passing through a circuit element on each of the opposed faces of the board;
d) treating the board to render the substrate exposed in the holes receptive to the action of a metallic plating solution;
e) removing the de-sensitising material;
f) printing an acid-resist mask on to both faces of the board, the mask leaving exposed only a small area of the board surrounding each hole therethrough; and
g) treating the board with an electroless nickel-plating solution to deposit nickel in the holes to the desired thickness to provide an electrical connection through each hole between two opposed conductive circuit elements.

Preferably, the de-sensitising material is a plating resist coating material. The metallic plating solution is preferably a non-homogeneous plating solution, which will only plate on to areas sensitised or treated to render them receptive to the plating. Such sensitising typically deposits a catalyst on to a cleaned and micro-etched surface to initiate the deposition of metal from its solution.

In comparison with conventionally produced boards, boards produced by the method of the invention are consistent in quality, and in uniformity of plating through the holes. Since metal is not built up equally over the whole board during plating, but is concentrated on the holes, the initial metal coating on the substrate can be selected to be the design conductor thickness, thus ensuring that all tracks meet the design specification. This is very important in controlling the impedance of high frequency circuits. The use of a single electroless plating operation before imaging ensures that no voids are present which might give rise to out-gassing, and contamination cannot occur. Further, although plating in the holes may not proceed uniformly initially, because of the variation in the surface smoothness in the drilled, or preferably punched hole, the resultant lack of smoothness in the surface of the plated metal through the hole is advantageous in providing a key for the solder in the subsequent use of the board.

The imaging of the conductive tracks is carried out before the holes are drilled or punched, and involves the formation of a positive resist image. This means that screen printing of an alkali-strippable resist can be used. This is not only a very low-cost operation, but requires only treatment in an alkaline solution to remove the resist, preferably the alkaline accelerator bath used after sensitising. Such treatment does not give rise to difficulties in waste treatment, requiring no organic solvents.

The method of the invention uses only one plating bath, reducing cost and the problems associated with treatment of waste from the plating stage. Capital costs and running costs are substantially smaller than with the conventional process. Control of the plating process is simple and a high degree of precision in achieving design plating thicknesses can be expected.

Benefits arise from the use of electroless nickel plating solutions to deposit conductive metal in the holes. Firstly, plating rates are very much higher than for copper solutions, typically around 25 µm/hr, so that a satisfactory thickness of metal can be built up in a much shorter time. Secondly, since nickel does not tarnish in the way that copper does, it is no longer necessary to coat the exposed copper on the board with solder. This is conventionally done in a hot-air levelling process, involving dipping the board into a bath of solder and then removing excess solder and levelling by means of a jet of hot air. This process is costly and potentially dangerous, and can give rise to health risks due to metal vapour emissions. Thirdly, electroless nickel plating does not require the presence of the formaldehyde required for copper plating. Since formaldehyde is carcinogenic, its avoidance is very desirable. Boards plated through the holes with nickel in accordance with the invention have been found to meet the highest quality standards, rendering them suitable for use in space and aerospace applications, while production costs are comparable with conventional standard production boards. The acid plating bath used in the electroless deposition of nickel does not attack paper phenolic materials, thus opening up such materials to high quality electroless through-hole plating.

### Brief Description of the Drawings

In the drawings:

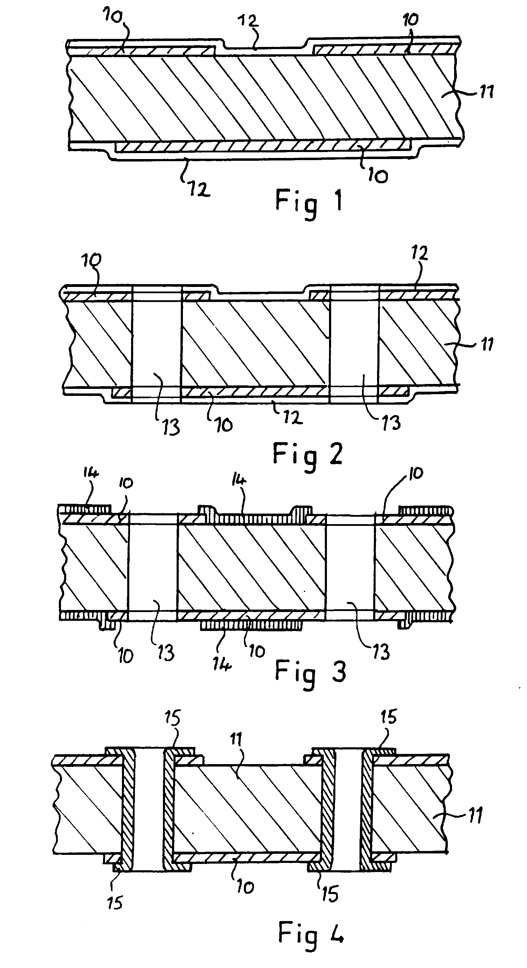

Figures 1 to 4 are diagrammatic sectional views through a board illustrating stages in a manufacturing process according to the present invention.

### Detailed Description of the Illustrated Method of the Invention

Referring to Figure 1, the method of the invention comprises as a first step the formation of the conductive circuit elements 10 on each surface of the substrate 11 by the conventional processes of forming a positive resist image, for example by silk screen printing, or photographically, and etching away the copper from the exposed parts of the board. A uniform coating 12 of an alkali-soluble plating resist is then applied to each surface of the board by silk screen printing or dry film application as a de-sensitising layer, and is cured, for example by the application of U.V. light.

Holes 13 are then punched through the board and the de-sensitising layer at the desired locations for interconnections between opposed circuit elements 10, yielding a configuration as shown in Figure 2. Treatment of the exposed substrate in the holes to render it receptive to electroless plating of nickel is then carried out in conventional manner, with initial cleaning, micro-etching and sensitising with any of the known electroless preparatory systems, for example the materials sold by MacDermid GB Ltd under reference 9027. The next stage in preparation is treatment by caustic soda as an accelerator, and this also has the effect of stripping off the de-sensitising resist layer 12.

A mask 14 of acid resist is then printed on each face of the board, leaving only a small area (approximately 2mm wide) around each hole exposed, as shown in Figure 3. Since the only area of the board prepared for plating of nickel is the exposed surface within and around the holes 13, treatment of the board in a strong electroless nickel plating solution, e.g. those sold by MacDermid GB Ltd under references ELNIC 105 or ELNIC 110, for approximately one hour, builds up nickel to the desired thickness in and around the holes only. This leaves the configuration illustrated in Figure 4. It is observed that the thickness of nickel 15 through the holes is generally uniform, and consistent across the area of the board, the plating of nickel being less subject to the faults which can arise in the conventional electroplating techniques.

Control of the electroless plating stage is conveniently achieved as follows. The boards are suspended in a tank of the plating solution, which is suitably circulated through an overflow tank, where it can be filtered, so as to maintain a constant volume in the plating tank. Air is bubbled through the plating tank to agitate the solution and ensure adequate mixing, and the supports for the boards are oscillated to ensure that fresh solution is constantly passed through the holes. The plating solution is replenished from a measured supply by a dosing pump or pumps, which operate at a constant predetermined rate, but which are controlled to switch on and off repeatedly so as to run for a set percentage of the total plating time. This is determined according to the amount of nickel to be deposited.

## Claims

1. A method of making a plate through hole printed circuit board, comprises the steps of:
a) forming conductive circuit elements (10) on two opposed faces of a paper phenolic containing substrate (11);
b) coating the substrate and circuit elements with a de-sensitising material (12);
c) forming holes (13) through the substrate, each hole passing through a circuit element on each of the opposed faces of the board;
d) treating the board to render the substrate exposed in the holes receptive to the action of a metallic plating solution;
e) removing the de-sensitising material;
f) printing an acid-resist mask (14) on to both faces of the board, the mask leaving exposed only a small area of the board surrounding each hole therethrough; and
g) treating the board with an electroless nickel-plating solution to deposit nickel (15) in the holes to the desired thickness to provide an electrical connection through each hole between two opposed conductive circuit elements..

2. A method according to Claim 1, wherein the de-sensitising material (12) is a plating resist coating material.

3. A method according to Claim 1 or 2, wherein the plating solution is a non-homogeneous plating solution.

4. A method according to any preceding claim, wherein step (d) comprises deposit of a catalytic material on the exposed substrate.

5. A method according to any preceding claim, wherein the holes (13) are formed by punching.

## Patentansprüche

1. Verfahren zur Herstellung einer durchkontaktierten Leiterplatte, das die folgenden Schritte umfaßt:
a) Ausbilden von Leiterbahnelementen (10) an zwei entgegengesetzten Oberflächen eines Phenolpapier enthaltenden Trägermaterials (11);
b) Beschichten des Trägermaterials und der Leiterbahnelemente mit einem desensibilisierenden Material (12);
c) Ausbilden von Löchern (13) durch das Trägermaterial, wobei jedes Loch durch ein Leiterbahnelement auf jeder der entgegengesetzten Oberflächen der Leiterplatte geht;
d) Behandeln der Leiterplatte, so daß das in den Löchern exponierte Trägermaterial für die Wirkung einer Plattierungslösung empfänglich wird;
e) Entfernen des desensibilisierenden Materials;
f) Aufdrucken einer Säure-Resist-Maske (14) auf beide Oberflächen der Leiterplatte, wobei die Maske nur einen kleinen Bereich exponiert läßt, der jeweils ein durch Leiterplatte gehendes Loch umgibt; und
g) Behandeln der Leiterplatte mit einer stromlosen Nickelplattierungslösung, so daß Nickel (15) in den Löchern in der gewünschten Dicke abgeschieden wird, um eine elektrische Verbindung durch jedes Loch zwischen zwei entgegengesetzten Leiterbahnelementen herzustellen.

2. Verfahren nach Anspruch 1, bei dem das desensibilisierende Material (12) ein Plattierungsresistbeschichtungsmaterial ist.

3. Verfahren nach Anspruch 1 oder 2, bei dem die Plattierungslösung eine nichthomogene Plattierungslösung ist.

4. Verfahren nach irgendeinem vorhergehenden Anspruch, bei dem Schritt (d) das Abscheiden eines katalytischen Materials an dem exponierten Trägermaterial umfaßt.

5. Verfahren nach irgendeinem vorhergehenden Anspruch, bei dem die Löcher (13) durch Stanzen ausgebildet werden.

## Revendications

1. Procédé de fabrication d'une plaquette à circuits imprimés à trous traversant la plaque, comprenant les étapes consistant à :
a) former des éléments de circuit conducteur (10) sur deux faces opposées d'un substrat (11) en papier laminé, lié par des résines phénoliques ;
b) revêtir le substrat et les éléments de circuit par une matière de désensibilisation (12) ;
c) former des trous (13) à travers le substrat, chaque trou passant à travers un élément de circuit sur chacune des faces opposées de la plaquette ;
d) traiter la plaquette pour rendre le substrat exposé dans les trous réceptif à l'action d'une solution de placage métallique ;
e) éliminer la matière de désensibilisation ;
f) imprimer un masque résistant aux acides (14) sur les deux faces de la plaquette, le masque laissant exposée seulement une petite zone de la plaquette entourant chaque trou traversant ; et
g) traiter la plaquette par une solution de placage de nickel sans courant pour déposer du nickel (15) dans les trous à l'épaisseur désirée pour assurer une connexion électrique à travers chaque trou entre deux éléments de circuit conducteur opposés.

2. Procédé selon la revendication 1, dans lequel la matière de désensibilisation (12) est une matière de revêtement de réserve de placage.

3. Procédé selon l'une des revendications 1 ou 2, dans lequel la solution de placage est une solution de placage non homogène.

4. Procédé selon l'une quelconque des revendications précédentes, dans lequel l'étape (d) comprend le dépôt d'une matière catalytique sur le substrat exposé.

5. Procédé selon l'une quelconque des revendications précédentes, dans lequel les trous (13) sont formés par poinçonnage.
